# EUROPEAN PATENT APPLICATION

(11) **EP 3 739 624 A1**
(43) Date of publication of application: **18.11.2020**
(21) Application number: 19174127.1
(22) Date of filing: 13.05.2019
(51) Int. Cl.: H01L 23/48, H01L 23/488, H01L 21/56, H01L 23/31, H01L 23/498, H01L 23/538, H01L 23/495, H01L 25/18, H01L 25/07

(54) **SEMICONDUCTOR ARRANGEMENT WITH A COMPRESSIBLE CONTACT ELEMENT ENCAPSULATED BETWEEN TWO CARRIERS AND CORRESPONDING MANUFACTURING METHOD**

(71) Applicant: Infineon Technologies Austria AG, 9500 Villach (AT)
(72) Inventor: FÜRGUT, Edward, 86453 Dasing (DE); GRUBER, Martin, 92421 Schwandorf (DE); PEDONE, Daniel, 81739 München (DE); SCHOLZ, Wolfgang, 82140 Olching (DE)
(74) Representative: Westphal, Mussgnug & Partner Patentanwälte mbB

(57) **Abstract**

A semiconductor arrangement and a method for forming a semiconductor arrangement are disclosed. The semiconductor arrangement includes: a first arrangement (1A) and a second arrangement (1B) each comprising a first surface (11A, 11B), a second surface (12A, 12B), and an electrode (21A, 21B) formed on the first surface (11A, 11B), wherein the first arrangement (1A) and the second arrangement (1B) are spaced apart from each other in a first direction (x) and arranged such that the first surface (11A) of the first arrangement (1A) faces the first surface (11B) of the second arrangement (1B), and wherein at least one of the first arrangement (1A) and the second arrangement (1B) comprises a semiconductor body (103A, 103B); a connector (3) electrically connecting the electrode (21A) of the first arrangement (1A) and the electrode (21B) of the second arrangement (1B), wherein the connector (3) is compressible in the first direction (x); and an encapsulant (4) filling a space between the first arrangement (1A) and the second arrangement (1B) and embedding the connector (3). The connector (3) may include a base section (30), one or more first legs (31A) extending from the base section (30) towards the electrode (21A) of the first arrangement (1A) and one or more second legs (31B) extending from the base section (30) towards the electrode (21B) of the second arrangement (1B). A pressure contact may be formed between the connector (3) and the electrode (21A, 21B) of at least one of the first arrangement (1A) and the second arrangement (1B) or alternatively the connector (3) may be fixed (e.g. soldered or welded) at the electrode (21A, 21B) of at least one of the first arrangement (1A) and the second arrangement (1B) by an electrically conducting compound. The encapsulant (4) may be a mold compound. The second surface (12A, 12B) of each of the first arrangement (1A) and the second arrangement (1B) may be at least partially not covered by the encapsulant (4) to allow for efficient cooling of the first and second arrangement (1A, 1B). A contact pin (104A, 104B) may protrude from the encapsulant (4), wherein the connector (3) is electrically connected to the contact pin (104A, 104B). The connector (3) may comprise a terminal section (33) that protrudes from the encapsulant (4). One semiconductor arrangement may include a plurality of connectors (3), wherein the connectors (3) may be arranged such that terminal sections (33.1-33.3) of several connectors protrude from the encapsulant (4) on one side, wherein these terminal sections (33.1-33.3) are arranged next to each other in a lateral direction along the one side and two (or more) terminal sections (33.1-33.6) may be arranged next to each other in the vertical direction (x), wherein the terminal sections that are arranged next to each other in the vertical direction may be aligned relative to each other or offset in the lateral direction. At least one of the first arrangement (1A) and the second arrangement (1B) may comprise a carrier (101A, 101B) forming the second surface (12A, 12B) and a semiconductor body (103A, 103B) arranged on the carrier (101A, 101B), wherein a surface of the semiconductor body (103A, 103B) facing away from the carrier (101A, 101B) forms the first surface (11A, 11B). T he carrier (101A, 101B) may be part of a leadframe. The carriers (101A, 101B) may each include a respective leg (102A, 102B) that adjoin each other and are therefore electrically connected, wherein both legs (102A, 102B) may protrude from the encapsulant or one of the legs (102A, 102B) is cut off and ends inside the encapsulant (4) where it is connected to the other one of the legs (102A, 102B), wherein the other one of the legs (102A, 102B) protrudes from the encapsulant (4). The carrier (101A, 101B) may also be a substrate (110A) comprising: an insulating carrier (111A, 111B), a first metallization (112A, 112B) formed on a first surface of the insulating carrier (111A, 111B) and a second metallization (113A, 113B) formed on a second surface of the insulating carrier (111A, 111B), wherein the second metallization (113A, 113B) forms the second surface (12A, 12B) of the respective arrangement (1A, 1B), and wherein the semiconductor body (103A, 103B) is formed on the first metallization (112A, 112B). The method for forming the semiconductor arrangement may comprise: placing the semiconductor arrangement in a first section (51) of a mold (50), closing the mold (5) by placing a second section (53) of the mold (50) on top of the first section (51); and filling a space (53) inside the mold (50) by the encapsulant (4), wherein closing the mold (50) comprises compressing the connector (3) arranged between the electrode (21A) of the first arrangement (1A) and the electrode (21B) of the second arrangement (1B) in the first direction (x).

## Description

This disclosure relates in general to a semiconductor arrangement and to a method for producing a semiconductor arrangement.

A semiconductor arrangement may include at least one semiconductor device, such as a transistor, a diodes, a sensor, or the like, integrated in a semiconductor body (die). The semiconductor body may be embedded in an encapsulant, such as a mold compound, that protects the semiconductor body and mechanically stabilizes the semiconductor arrangement. The semiconductor arrangement may further include contacts, such as contact pins protruding from the encapsulant, through which the at least one semiconductor device inside the encapsulant may be connected with other semiconductor devices.

During operation of the at least one semiconductor device power may be dissipated in the semiconductor device, which may result in a heating up of the semiconductor arrangement. Further, a plurality of semiconductor arrangements of the same type may be arranged on one carrier, such as a PCB (Printed Circuit Board), wherein it may desirable to cool two or more of these semiconductor arrangements by the same cooling element. This, however, requires that the individual semiconductor arrangements essentially have the same size, in particular the same height.

There is therefore a need for a semiconductor arrangement with an encapsulant that can be produced with a well-defined size.

One example relates to a semiconductor arrangement. The semiconductor arrangement includes a first arrangement and a second arrangement each including a first surface, a second surface, and an electrode formed on the first surface. The first arrangement and the second arrangement are spaced apart from each other in a first direction and arranged such that the first surface of the first arrangement faces the first surface of the second arrangement, wherein at least one of the first arrangement and the second arrangement comprises a semiconductor body. The semiconductor arrangement further includes a connector electrically connecting the electrode of the first arrangement and the electrode of the second arrangement, wherein the connector is compressible in the first direction, and an encapsulant filling a space between the first arrangement and the second arrangement and embedding the connector.

Another example relates to a method. The method includes placing a semiconductor arrangement in a first section of a mold, closing the mold by placing a second section of the mold on top of the first section, and filling a space inside the mold by an encapsulant. The semiconductor arrangement includes a first arrangement and a second arrangement each including a first surface, a second surface, and an electrode formed on the first surface. The first arrangement and the second arrangement are spaced apart from each other in a first direction and arranged such that the first surface of the first arrangement faces the first surface of the second arrangement, wherein at least one of the first arrangement and the second arrangement includes a semiconductor body. The semiconductor arrangement further includes a connector arranged between the electrode of the first arrangement and the electrode of the second arrangement and electrically connecting the electrode of the first arrangement and the electrode of the second arrangement, wherein the contact element is compressible in the first direction, and wherein closing the mold comprises compressing the connector in the first direction.

Examples are explained below with reference to the drawings. The drawings serve to illustrate certain principles, so that only aspects necessary for understanding these principles are illustrated. The drawings are not to scale. In the drawings the same reference characters denote like features.
Figure 1 shows a vertical cross sectional view of a semiconductor arrangement that includes a flexible connector between an electrode of a first arrangement and an electrode of a second arrangement;
Figures 2A-2D illustrate one example of a method for forming a semiconductor arrangement of the type shown in Figure 1;
Figures 3A-3B illustrate a perspective view and a top view, respectively, of one example of the connector;
Figures 4-5 illustrate top views of connectors according to further examples;
Figures 6A and 6B each show a vertical cross sectional view of a semiconductor arrangement in which each of the first arrangement and the second arrangement includes a leadframe and a semiconductor body;
Figures 7A-7B show top views of examples of a first arrangement and a second arrangement, respectively, of the type shown in Figure 6;
Figure 7C shows an equivalent circuit diagram of a semiconductor arrangement of the type shown in Figure 6 when implemented with first and second arrangements of the type illustrated in Figures 7A and 7B;
Figure 8A shows a top view of a first arrangement according to another example;
Figure 8B shows an equivalent circuit diagram of a semiconductor arrangement of the type shown in Figure 6 when implemented with a first arrangement of the type illustrated in Figure 8A and a second arrangement of the type illustrated in Figure 7B;
Figure 9 shows a top view of a second arrangement according to another example and of an example of a connector with a contact terminal, wherein the contact terminal is connected to a contact pin protruding from an encapsulant;
Figure 10 shows another example of a connector that includes a contact terminal;
Figure 11 shows a modification of the second arrangement shown in Figure 9, wherein the contact terminal of the connector protrudes from an encapsulant;
Figure 12 shows a modification of the arrangement shown in Figure 6;
Figures 13A-13B show top views of examples of a first arrangement and a second arrangement, according to another example;
Figure 13C shows an equivalent circuit diagram of a semiconductor arrangement of the type shown in Figures 13A-13B;
Figures 14A-14B show top views of examples of a first arrangement and a second arrangement, according to another example;
Figures 15A and 15B each show a vertical cross sectional view of a semiconductor arrangement in which each of the first arrangement and the second arrangement includes a substrate with a first metallization and a second metallization and a semiconductor body;
Figure 16 shows a vertical cross sectional view of a semiconductor arrangement according to another example;
Figure 17 shows a vertical cross sectional view of a semiconductor arrangement according to yet another example; and
Figures 18A and 18B illustrate a semiconductor arrangement according to another example.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

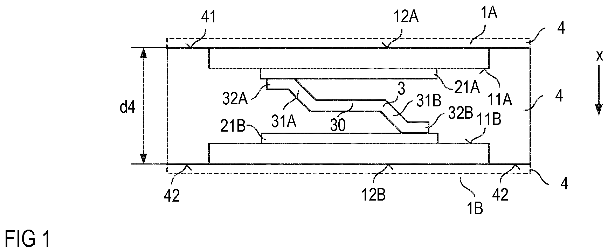

Figure 1 shows a vertical cross sectional view of a semiconductor arrangement according to one example. This semiconductor arrangement includes a first arrangement 1A and a second arrangement 1B, wherein at least one of the first arrangement 1A and the second arrangement 1B includes a semiconductor body. This semiconductor body, however, is not illustrated in Figure 1. According to one example, only one of the first arrangement 1A and the second arrangement 1B includes a semiconductor body. According to another example, each of the first arrangement 1A and the second arrangement 1B includes a semiconductor body. Examples of how the first and second arrangements 1A, 1B may be implemented are explained in detail herein further below.

Referring to Figure 1, each of the first arrangement 1A and second arrangement 1B includes a first surface 11A, 11B, a second surface 12A, 12B opposite the respective first surface 11A, 11B, and an electrode 21A, 21B formed on the first surface 11A, 11B. The first arrangement 1A and the second arrangement 1B are spaced apart from each other in a first direction x of the semiconductor arrangement. Further, the first arrangement 1A and the second arrangement 1B are arranged such that the first surface 11A of the first arrangement 1A faces the first surface 11B of the second arrangement 1B. A connector 3 electrically connects the electrode 21 of the first arrangement 1A and the electrode 21B of the second arrangement 1B.

Further, an encapsulant 4 fills a space between the first arrangement 1A and the second arrangement 1B and embeds the connector 3. According to one example, illustrated in solid lines in Figure 1, the encapsulant 4 is formed such that the second surface 12A, 12B of each of the first arrangement 1A and the second arrangement 1B is at least partially not covered by the encapsulant 4. According to one example, the second surface 12A, 12B of each of the first arrangement 1A and the second arrangement 1B is completely not covered by the encapsulant 4. According to another example, illustrated in dashed lines in Figure 1, the encapsulant 4 is formed such that the second surface 12A, 12B of at least one of the first arrangement 1A and the second arrangement 1B is covered by the encapsulant 4, wherein in the example shown in Figure 1 the second surface of both the first arrangement 1A and the second arrangement 1B is covered by the encapsulant 4.

According to one example, the encapsulant is a mold compound. According to one example, the mold compound includes a resin such as, for example, an epoxy, a silicone, a polyimide, a bismaleimide (BMI), or composites thereof, and a filler such as, for example, silicon oxide (SiO₂), aluminum oxide (Al₂O₃), boron nitride BN, aluminum nitride AlN, diamond, or composites thereof. Further, the encapsulant, before encapsulation, may have one of different states of aggregation such as, for example, pellet, liquid, granulate, sheet.

The connector 3 is compressible in the first direction x. That is, the connector 3 may be compressed in the first direction x to a certain extent without being damaged or destroyed. This may help to produce the semiconductor arrangement in such a way that a distance d4 between the second surface 12A of the first arrangement 1A and the second surface 12B is precisely adjusted. This may be important for various reasons.

If, for example, a plurality of semiconductor arrangements of the type shown in Figure 1 is mounted next to each other on a carrier and the individual semiconductor arrangements have essentially the same height, one common cooling element may easily be mounted on those surfaces of the individual semiconductor arrangements facing away from the carrier. By virtue of the semiconductor arrangements having essentially the same height a low thermal resistance can be provided between the cooling element and the surface of each of the individual semiconductor arrangements. According to one example, "essentially the same height" means that the individual semiconductor arrangements deviate less than 100 micrometers, less than 50 micrometers, or even less than 10 micrometers from an average height of the individual semiconductor arrangements. This, however, is only one example in which it is important to exactly adjust the height of the semiconductor arrangement. Further, in the semiconductor arrangement of the type shown in Figure 1, the first and second arrangements 1A, 1B can be cooled in an efficient way when the semiconductor arrangement is implemented such that the respective second surface 12A, 12B of each of the first and second arrangements is not covered or at least partially not covered by the encapsulant. For cooling purposes, a respective cooling element (not shown in Figure 1) may be placed on at least one of the second surfaces 12A, 12B.

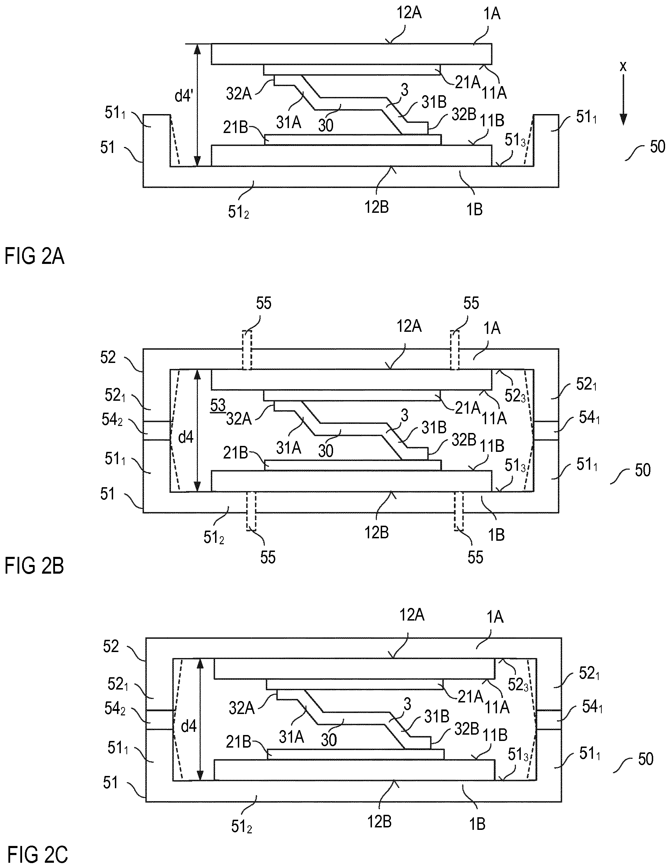

As explained above, the compressible connector 3 helps to precisely adjust the height d4 of the semiconductor arrangement. This is explained with reference to Figures 2A to 2C. These figures schematically illustrate the semiconductor arrangement during one example of a manufacturing process.

Referring to Figure 2A, this process includes placing the semiconductor arrangement in a first section 51 of mold 50. This first section 51 of the mold 50 includes a bottom 51₂ with a bottom surface 51₃ and a sidewall 51₁, wherein the bottom 512 and the sidewall 51₁ form a well-like arrangement. Inner sections of the sidewall 51₁ may be slanted in such a way that the well-like arrangement formed by the bottom 51₂ and the sidewall 51₁ narrows towards the bottom 51₂. This may make it easier to remove the semiconductor arrangement from the mold 50 after the manufacturing process.

Referring to Figure 2A, the semiconductor arrangement may be placed in the first section 51 of the mold 50 such that a second surface of one of the first arrangement 1A and the second arrangement 1B abuts a bottom surface 51₃ of the mold 51. Just for the purpose of illustration, in the example shown in Figure 2A, the second surface 12B of the second arrangement 1B abuts the bottom surface 51₃ of the mold 51.

At the stage of the manufacturing process illustrated in Figure 2A, the semiconductor arrangement includes the first arrangement 1A, the second arrangement 1B and the connector 3, but does not include the encapsulant 4. Further, at this stage of the manufacturing process, a height d4' of the semiconductor arrangement, which is a shortest distance between the second surface 12A of the first arrangement 1A and the second surface 12B of the second arrangement 1B, is greater than the height d4 of the finished semiconductor arrangement.

Referring to Figure 2B, the method further includes closing the mold 50 by placing a second mold section 52 on top of the first mold section 51. The second mold section 52 includes a cover 52₂ with a cover surface 52₃ and a sidewall 52₁, wherein the cover 52₂ and the sidewall 52₁ form a well-like arrangement. Inner sections of the sidewall 52₁ may be slanted in such a way that the well-like arrangement formed by the cover 52₂ and the sidewall 52₁ narrows towards the cover 52₂. This may make it easier to open the mold 50 after the manufacturing process. The first mold section 51 and the second mold section 52 form a cavity 53, wherein the semiconductor arrangement is arranged inside this cavity 53 after closing the mold 50.

Closing the mold 50 by placing the second mold section 52 on top of the first mold section 51 includes compressing the connector 3 in the first direction x into a final form and position. Compressing the connector 3 includes reducing the distance between the second surfaces 12A, 12B of the first and second arrangements 1A, 1B from a first distance value d4' illustrated in Figure 2A to the final distance value d4 illustrated in Figures 1 and 2B. This final distance value d4, that is, the final height of the semiconductor arrangement is defined by a distance between the bottom surface 51₃ of the first mold section and the cover surface 52₃ of the second mold section 52, wherein the second surface of one of the first arrangement 1A and the second arrangement 1B abuts the bottom surface 51₂ and the second surface of the other one of the first arrangement 1A and the second arrangement 1B abuts the cover surface 52₂. Just for the purpose of illustration, in the example shown in Figure 2B, the second surface 12A of the first arrangement 1A abuts the cover surface 52₂ and the second surface 12B of the second arrangement 1B abuts the bottom surface 51₂.

According to one example, a difference between the first distance d4' and the final distance d4 is between 50 micrometers and 500 micrometers, in particular between 50 micrometers and 200 micrometers. The connector 3 is compressed in the first direction x by a distance that is given by this difference. According to one example, a height of the connector 3 in the vertical direction, before compressing the connector 3, is between 0.5 millimeters (=500 micrometers) and 5 millimeters (=5000 micrometers).

Referring to Figure 2C, the method further includes filling the cavity 53 shown in Figure 2B by the encapsulant 4. Filling the cavity 53 by the encapsulant 4 may include introducing an encapsulant material in liquid form through an opening 54₁ into the mold 50, wherein air or another gas filling the cavity 53 after closing the mold 50 may exhaust through another opening 54₂ of the mold 50. Further, a vacuum may be generated by drawing the air or gas filling the cavity 53 via the at least one second opening 54₂ from the cavity. Generating a vacuum may help to avoid the formation of voids in the encapsulant.

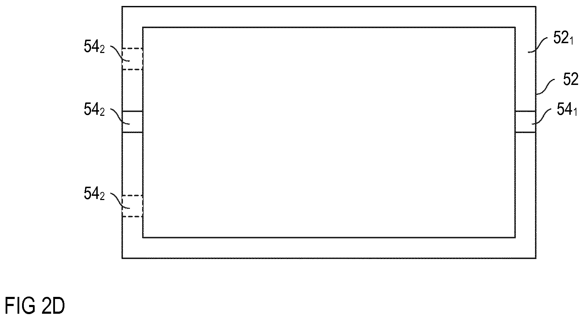

According to one example, the openings 54₁, 54₂ are formed by notches in the sidewall 52₁ of the second mold section 52. This is illustrated in Figure 2D which illustrates a top view of the sidewall 52₁ of the second mold section 52. However, forming the openings by notches in the sidewall 52₁ of the second mold section 52 is only an example. According to another example (not shown), these openings are formed by notches in the sidewall of the first mold section. According to yet another example, one or more openings are formed by notches in the sidewall of the first mold section and , one or more openings are formed by notches or recesses in the sidewall of the second mold section.

The semiconductor arrangement may include one or more contact legs (contact pins) that protrude from the encapsulant 4, which will be explained in further detail below. During the manufacturing process illustrated in Figures 2A to 2D, these legs may protrude from the mold 50 via the at least one second opening 54₂.

Finishing the semiconductor arrangement further includes curing encapsulant 4, opening the mold 51, and removing the semiconductor arrangement from the mold 51. In the finished semiconductor arrangement, the connector 3 is embedded by the encapsulant 4 so that the encapsulant 4 maintains the connector 3 in the final form and position achieved by closing the mold 51 by the cover 53.

Figure 2A illustrates the semiconductor arrangement (without the encapsulant 4) after placing the semiconductor arrangement in the first mold section 51. Placing the semiconductor arrangement in the first mold section 51 may include placing one of the first and second arrangements 1A, 1B, on the bottom surface 51₃ of the first mold section 51, placing the connector 3 on the electrode of the respective arrangement, and placing the other one of the first and second arrangements 1A, 1B on the connector 3 such that the electrode 21A of this arrangement is in contact with the connector 3. Just for the purpose of illustration, in the example shown in Figure 2A, the second surface 12B of the second arrangement 1B has been placed on the bottom surface 51₃ of the first mold section 51, the connector 3 has been placed on the electrode 21B of the second arrangement 1B, and the first arrangement 1A has been placed on top of the connector 3. It should be noted that in Figures 1, 2A and 2B only one section of the connector 3 is illustrated. As explained herein further below, the connector 3 may be implemented in such a way that the connector 3 can be placed on the electrode 21B of the second arrangement 1B in a stable way without tilting over and such that the first arrangement 1A can be placed on the connector 3 in a stable way.

The connector 3 may simply be placed on the electrode 21B of the second arrangement 1B, that is, without a solder, for example. Equivalently, the electrode 21A of the first arrangement 1A may directly be placed on the connector 3. In this way, in the finished semiconductor arrangement, pressure contacts are formed between the connector 3 and the electrode 21A, 21B of each of the first arrangement 1A and the second arrangement 1B.

According to another example, the connector 3 is soldered or welded to the electrode 21A, 21B of one of the first and second arrangements 1A, 1B before placing the arrangement in the first mold section 51 and a pressure contact is formed between the connector 3 and the electrode of the other one of the first and second arrangements 1A, 1B. According to yet another example, the connector 3 is soldered or welded using an electrically conducting compound to the electrode 21A, 21B of each of the first and second arrangements 1A, 1B. Soldering the connector 3 to the electrode 21A, 21B of each of the first and second arrangements 1A, 1B may include (a) forming a solder pad (not shown in the drawings) on each of these electrodes 21A, 21B; (b) placing the connector 3 on the solder pad of one of these electrodes 21A, 21B; (c) placing the other one of these electrodes 21A, 21B on the connector 3 such that the respective solder pad is in contact with the connector 3; and (d) melting the material of the solder pads in an oven process, for example, so that after curing the solder pad a fixed connection is formed between the connector 3 and the electrodes 21A, 21B

According to one example, the connector 3 is not only compressible in the first direction x, but the connector 3 is also resilient, so that the connector 3 forms a springlike connection element that provides a reliable electrical connection between the electrodes 21A, 21B of the first and second arrangements 1A, 1B. When the connector 3 is compressed by placing the second mold section 52 on top of the first mold section 51 the connector creates a counter pressure that acts against the pressure that closes the mold 50. This counter pressure ensures that the connector 3 remains in electrical contact with the first and second electrode 21A, 21B so that pressure contacts are formed between the connector 3 and the first and second electrode 21A, 21B.

In the example illustrated in Figures 1, 2A and 2B, the connector 3 includes a base section 30, a first leg 31A extending from the base section 30 towards the electrode 21A of the first arrangement 1A and a second leg 31B extending from the base section 30 towards the electrode 21B of the second arrangement 1B. A first contact section 32A is arrangement at the end of the first leg 31A and connected to the electrode 21A of the first arrangement 1A, and a second contact section 32B is arranged at the end of the second leg 31B and in contact with the electrode 21B of the second arrangement 1B. The base section 30, the first and second legs 31A, 31B and the first and second contact section 32A, 32B may be formed by one piece of metal. According to one example, each of the first leg 31A and the second leg 31B is inclined relative to the base section 30, wherein an angle between the base section 30 and each of the first leg 31A and the second leg 31B is selected from between 30° and 60°, for example. In this way, the flexibility of the connector 3 can be achieved. The connector 3 may be formed from a sheet metal by die cutting and bending, or etching and bending. According to one example, a thickness of the sheet metal is selected from between 100 micrometers and 1000 micrometers, in particular from between 200 and 300 micrometers or from between 500 and 1000 micrometers. According to another example, the connector is formed by 3D printing or by milling. According to one example, the connector 3 includes at least one of the following materials: copper (Cu); a copper alloy such as for example an iron-copper (Fe-Cu) or chromium-copper (Cr-Cu) alloy; a copper-molybdenum (Cr-Mo) composite; aluminum (Al); silver (Ag); or a silver alloy. Contact surfaces, which are surfaces of the connector 3 that are in contact with the electrodes 21A, 21B, may additionally include a dressing made of silver, nickel-phosphorous (NiP), or the like.

Referring to Figure 1, the encapsulant 4 may be formed such that it covers the second surfaces 12A, 12B of the first and second arrangement. A semiconductor arrangement of this type may be formed by a mold 50 that additionally includes retractable pins 55 that are illustrated in dashed lines in Figures 2A to 2C. These pins 55, which are illustrated in a retracted position in Figures 2A to 2C, can be moved into the cavity 53 so as to form spacers between the bottom surface 51₃ and the cover surface 52₃ on the one side and the second surfaces 12A, 12B of the first and second arrangements 1A, 1B on the other side. These pins 55 remain in place until the cavity 53 has been filled by the encapsulant 4, wherein filling the cavity 53 in this case also includes filling spaces between the bottom surface 51₃ and the cover surface 52₃ and the second surfaces 12A, 12B. The pins 55 are retracted before the encapsulant is cured so the encapsulant also fills spaces formed by retracting the pins 55.

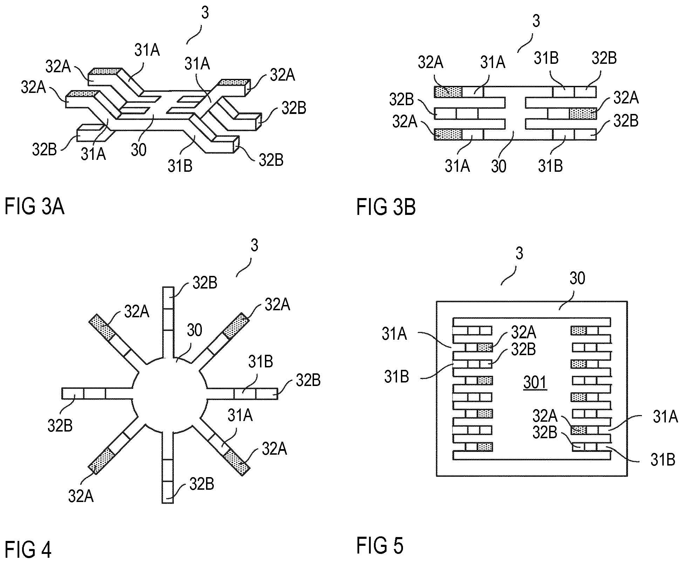

Figures 3A and 3B illustrate a connector according to one example, wherein Figure 3A shows a perspective view and Figure 3B shows a top view of the connector. In this example, the connector includes three first legs 31A, and three second legs 31B. The first legs 31A are arranged at the base section 30 in such a way that these first legs 31A and the respective contact sections 32A form a tripod. Equivalently, the second legs 32B and the respective contact sections 32B form a tripod. In the example shown in Figure 3A, this is obtained by arranging two first legs 31A and one second leg 31B alternatingly on one side of the base section 30 and by arranging two second legs 31B and one first leg 31A alternatingly on an opposite side of the base section 30. The tripod arrangement of the second legs 31B with the second contact sections 32B makes it possible to place the connector 3 on the electrode 21B of the first arrangement 1B in a stable fashion during the manufacturing process. Further, the tripod arrangement of the first legs 31A with the respective contact sections 32A makes it possible to place the first arrangement 1A in a stable fashion on the connector 3 in the manufacturing process.

It should be noted that implementing the connector 3 in the way illustrated in Figures 3A and 3B is only one of a plurality of various ways in which the connector 3 may be implemented. Just for the purpose of illustration, two further examples are illustrated in Figures 4 and 5. In the example shown in Figure 4, the base section 30 is circular and four first legs 31A and four second legs 31B are arranged alternatingly along a circumference of the base section 30. Implementing the connector 3 with four first legs 31A and four second legs 31B is only an example. In general, a connector 3 of the type shown in Figure 4 includes three or more first legs 31A and three or more second legs 31B.

In the example shown in Figures 3A and 3B, the base section 30 is essentially rectangular and the first and second legs 31A, 31B extend from two opposite outer sides of the base section 30. In the example shown in Figure 5, the base section 30 has a rectangular opening 301, wherein a plurality of first legs 31A and a plurality of second legs 31B are arranged alternatingly along each of two opposite sides of the opening 301. In the example shown in Figure 5, the connector 3 includes eight first legs 31A and eight second legs 31B. This, however, is only an example. In general, a connector of the type shown in Figure 5 may include at least three first legs 31A and at three second legs 31B, wherein neither the at least three first legs 31A nor the at least three second legs 31B are arranged in line. Further, it is also possible to implement the opining 301 with any other geometry different from a rectangle.

Referring to the above, each of the first arrangement 1A and the second arrangement 1B may be implemented in various ways, wherein at least one of the first arrangement 1A and the second arrangement 1B includes a semiconductor body. Some examples for implementing the first and second arrangements 1A, 1B are explained in the following.

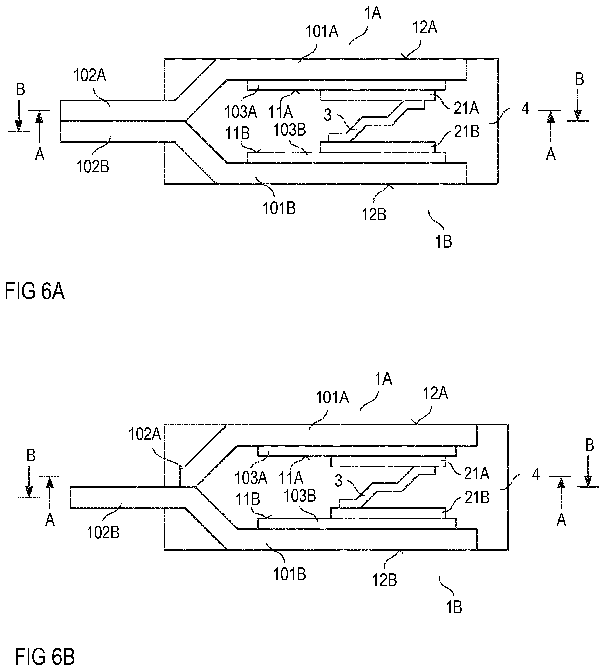

Figure 6A shows a vertical cross sectional view of a semiconductor arrangement according to one example. In this arrangement, each of the first arrangement 1A and the second arrangement 1B includes a carrier 101A, 101B, wherein the carrier 101A, 101B forms the respective first surface 12A, 12B. Further, each of the first arrangement 1A and the second arrangement 1B includes a semiconductor body 103A, 103B that is mounted on the respective carrier 101A, 101B on a side facing away from the respective second surface 12A, 12B. The semiconductor body 103A of the first arrangement 1A forms the first surface 11A of the first arrangement 1A, and the semiconductor body 103B of the second arrangement 1B forms the first surface 11B of the second arrangement 1B. Accordingly, the electrode 21A of the first arrangement 1A is arranged on the semiconductor body 103A of the first arrangement 1A and the electrode 21B of the second arrangement 1B is arranged on the semiconductor body 103B of the second arrangement 1B.

According to one example, at least one of the first carrier 101A and the second carrier 101B is part of a leadframe, wherein each of the first carrier 101A and the second carrier 101B may be part of a leadframe. The carrier 101A may also be referred to as base plate of the leadframe.

Referring to Figure 6A, each of the carriers 101A, 101B may include a respective leg 102A, 102B that adjoin each other and are therefore electrically connected. Both legs 102A, 102B may protrude from the encapsulant.

According to another example shown in Figure 6B, one of the legs 102A, 102B is cut off and ends inside the encapsulant 4 where it is connected to the other one of the legs 102A, 102B, wherein the other one of the legs 102A, 102B protrudes from the encapsulant 4. Just for the purpose of illustration, in the example shown in Figure 6B, the leg 102A of the first arrangement 1A has been cut off and the leg 102B of the second arrangement 1B protrudes from the encapsulant 4.

The carriers 101A, 101B and the respective legs 102A, 102B are also compressible in the first direction and, therefore, make it possible that the connector 3 is compressed in the manufacturing process.

Various kinds of semiconductor devices may be implemented in the semiconductor bodies 103A, 103B, wherein the semiconductor body may include any kind of semiconductor material, such as for example silicon (Si), silicon carbide (SiC), gallium arsenide (GaAs), gallium nitride (GaN), or the like. According to one example, a vertical transistor device such as a vertical MOSFET (Metal Oxide Semiconductor Field-Effect Transistor), a vertical IGBT (Insulated Gate Bipolar Transistor), or a vertical JFET (Junction Field-Effect Transistor) is integrated in the semiconductor body 103A of each of the first arrangement 1A and the second arrangement 1B.

In the following, the semiconductor body 103A of the first arrangement 1A is also referred to as first semiconductor body, the electrode 21A of the first arrangement 1A is also referred to as first electrode, the semiconductor body 103B of the second arrangement 1B is also referred to as second semiconductor body, and the electrode 21B of the second arrangement 1B is also referred to as second electrode. Further, the transistor device integrated in the first semiconductor body 103A is referred to as first transistor device and the transistor device integrated in the second semiconductor body 103B is referred to as second transistor device in the following. According to one example, each of the first transistor device and the second transistor device is a vertical MOSFET or a vertical IGBT and the first electrode 21A is source electrode of the first transistor device and the second electrode 21B is a source electrode of the second transistor device. In this example, the connector 3 electrically connects the source electrodes of the transistor devices integrated in the first and second semiconductor bodies 103A, 103B.

A drain region (which may also be referred to as collector region in an IGBT) of the first transistor device is formed by a surface of the first semiconductor body 103A that is mounted on the carrier 101A (which is also be referred to as first carriers in the following). Equivalently, a drain region of the second transistor device is formed by a surface of the second semiconductor body 103B that is mounted on the second carrier 101B (which is also referred to as second carrier in the following). Each of the first and second semiconductor bodies 103A, 103B may be mounted on the respective carrier 101A, 101B in a conventional way such as, for example, by soldering or the like. Further, each of the semiconductor bodies 103A, 103B may include a metallization on the surface that faces the respective lead frame 101A, 101B and forms a drain electrode of the respective transistor device. However, such solder layers or metallization layers are not illustrated in Figure 6.

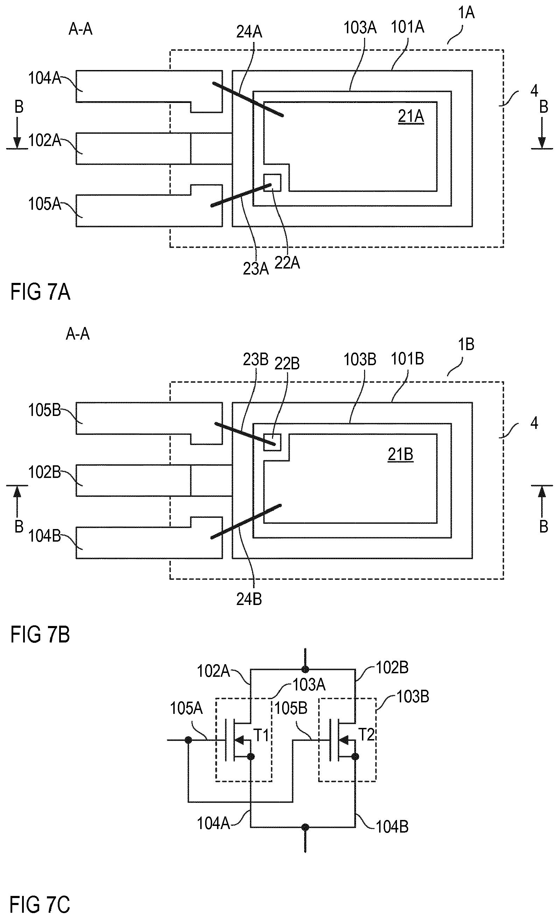

Figure 7A shows a top view of the first arrangement 1A in a plane A-A illustrated in Figure 6 and Figure 7B shows a top view of the second arrangement 1B in a plane B-B shown in Figure 6. The connector 3 and the encapsulant 4 are omitted in the illustrations according to Figures 7A and 7B. Referring to Figures 7A and 7B, each of the transistor devices integrated in the first and second semiconductor body 103A, 103B further includes a gate electrode 22A, 22B on the same side of the semiconductor body 103A, 103B as the electrode 21A, 21B (which forms the respective source electrode). The gate electrode 22A of the first transistor device is connected to a first gate leg 105A, and the gate electrode 22B of the second transistor device is connected to a second gate leg 105B. Each of these first and second gate legs 105A, 105B may protrude from the encapsulant 4. According to another example, only one of the two gate legs protrudes from the encapsulant 4, while the other gate leg is internally connected inside the encapsulant 4 to the gate leg protruding from the encapsulant 4.

Equivalently, the source electrode 21A of the first transistor device is connected to a first source leg 104A and the source electrode 21B of the second transistor device is connected to a second source leg 104B. Each of these first and second source legs 104A, 104B may protrude from the encapsulant 4. According to another example, only one of these first and second source legs 104A, 104B protrudes from the encapsulant 4, while the other one of the first and second source legs 104A, 104B is internally connected to the source leg protruding from the encapsulant 4. Connections 23A, 23B, 24A, 24B between the gate and source electrodes 22A, 22B, 21A, 21B and the respective legs 105A, 105B, 104A, 104B may be implemented in a conventional way. Each of these connections 23A, 23B, 24A, 24B may include at least one bond wire (as illustrated in Figures 7A and 7B) or a clip (not illustrated). Further, as the source electrodes 21A, 21B are connected with each other by the connector 3 one of the connections 24A, 24B would be sufficient to connect both source electrodes 21A, 21B to the contact pins 104A, 104, so that the other connection may be omitted.

Just for the purpose of illustration, the transistor device illustrated in Figure 7A includes three terminals (pins), a gate terminal formed by the gate leg 105A, a source terminal formed by the source leg 104A, and drain terminal formed by the drain leg 102A. This, however, is only an example. According to another example (not shown), the transistor device may include a further source terminal connected to the source electrode (which is formed by the electrode 21). In this case, one of the source terminals is configured to conduct a load current and the other one of the source terminals together with the gate terminal forms a drive input of the transistor device.

In a semiconductor arrangement of the type shown in Figures 6A and 6B, when implemented with vertical transistor devices of the type shown in Figures 7A and 7B, the two transistor devices are connected in parallel. That is, the gate electrodes 22A, 22B of the two transistor devices are connected, the source electrodes 21A, 21B of the two transistor devices are connected, and the drain electrodes connected to the carriers 101A, 101B are connected. An equivalent circuit diagram of a semiconductor arrangement of this type is illustrated in Figure 7C. In the equivalent circuit diagram shown in Figure 7C, circuit nodes of the two transistor devices are labelled with the same reference characters as the structural elements shown in Figures 7A and 7B that form the respective circuit nodes. Thus, for example, a gate node of the first transistor device T1 integrated in the first semiconductor body 103A is labelled with the reference character 105A of the first gate leg, a gate node of the second transistor device T2 integrated in the second semiconductor body 103B is labelled with the reference character 105B of the second gate leg, etc.

Just for the purpose of illustration, the transistor devices illustrated in Figure 7C are n-type MOSFETs. This, however, is only an example. Any other type of vertical transistor device may be used instead of a vertical n-type MOSFET as well.

In the example illustrated in Figures 7A and 7B, first electrodes 21A, 21B (which are source electrodes in this example) of the two arrangements are connected by the connector 3 (not shown in Figures 7A and 7B). The further electrodes 22A, 22B (which are gate electrodes in this example) may only be connected to respective contact pins through bond wires 24A, 24. According to another example, these further electrodes 22A, 22B are electrically connected with each other by another connector (not shown) of the same type as connector 3. In this case, one of the connections 23A, 23B may be omitted.

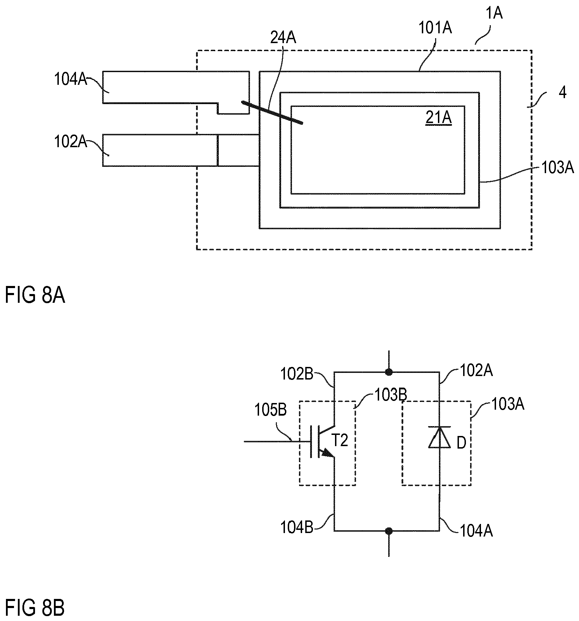

Implementing a vertical transistor device in each of the first and second semiconductor body 103A, 103B is only an example. According to another example, a vertical transistor device is integrated in one of the first semiconductor body 103A and a second semiconductor body 103B and a vertical diode is integrated in the other one of the first semiconductor body 103A and the second semiconductor body 103B. According to one example, the vertical diode is integrated in the first semiconductor body 103A. A top view of the first arrangement 1A in this example is illustrated in Figure 8A. The first electrode 21A either forms an anode electrode or a cathode electrode of the diode, while the surface of the semiconductor body 103A mounted on the lead frame 101A forms the other one of the anode or the cathode of the diode. The first electrode 21A (like in the example illustrated in Figure 7A) is connected to a contact leg 104A. This contact leg 104A either protrudes from the encapsulant 4 or is electrically connected to the source leg 104B of the second arrangement 1B inside the encapsulant.

Figure 8B shows an equivalent circuit diagram of a semiconductor arrangement that includes a first arrangement 1A of the type illustrated in Figure 8A and a second arrangement 1B of the type illustrated in Figure 7B. Just for the purpose of illustration it is assumed that the vertical transistor device integrated in the second semiconductor body 103B is a vertical IGBT, an anode of the diode D integrated in the first semiconductor body 103A is formed by the first electrode 21A and the leg 104A, and a cathode of the diode D is formed by the carrier 101A. In this case, the anode of the diode D is connected to the source node (emitter node) of the IGBT, which is formed by the second source leg 104B, and a cathode of the diode D is connected to a drain node (collector node) of the IGBT T2, which is formed by the carrier 101B.

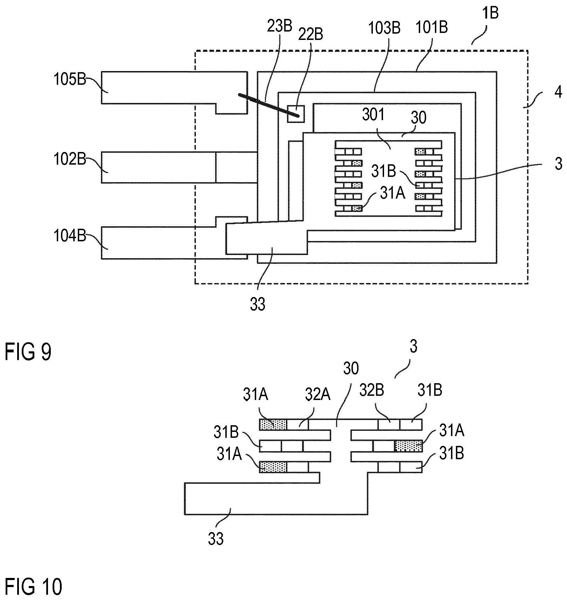

In the examples explained with reference to Figures 7A to 7C and 8, each of the first electrode 21A and the second electrode 21B is connected to a respective leg 104A, 104B by a respective connection element 24A, 24B, wherein at least one of these legs 104A, 104B protrudes from the encapsulant 4. This, however, is only an example. According to another example illustrated in Figure 9, the connector 3, includes a flat conductor that extends away from the base section 30 and is connected to at least one of the legs 104A, 104B. Figure 9 shows a top view of the second arrangement 1B and a connector 3 of this type. The first arrangement 1A may be implemented as illustrated in one of Figures 7A and 8A.

The connector 3 illustrated in Figure 9 is based on the connector illustrated in Figure 5 and additionally includes the flat conductor 33 connected to the second source leg 104B and the corresponding leg 104A of the first arrangement 1A (not shown in Figure 9). However, implementing the connector 3 in this way is only an example. This, however, is only an example. According to another example, illustrated in Figure 10, a connector 3 that is based on a connector of the type illustrated in Figures 3A and 3B may be used as well.

Referring to Figure 9, the flat conductor 33 of the connector 3 may be connected to the source leg 104B of the second arrangement 1B, wherein this source leg 104B protrudes from the encapsulant 4. The corresponding leg 104A of the first arrangement 1A (not shown in Figure 9) may be omitted.

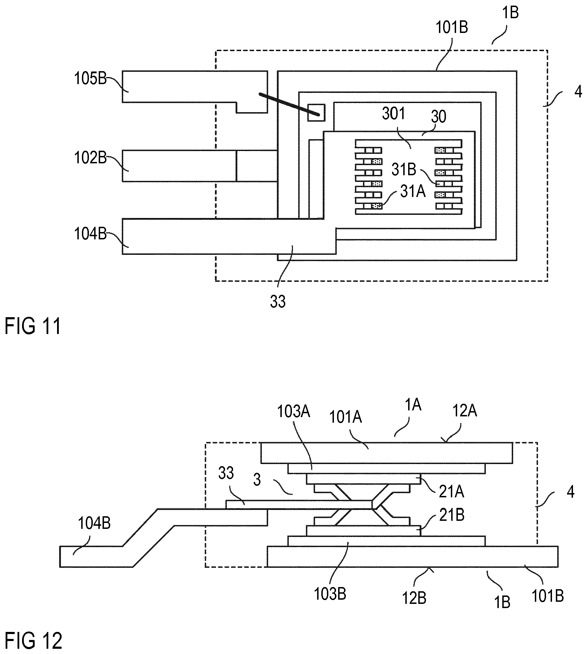

According to another example, illustrated in Figure 11, the flat conductor 33 protrudes from the encapsulant 4 thereby forming the respective leg 104B. The corresponding leg 104A of the first arrangement 1A (not shown in Figure 11) may be omitted.

Referring to the above, from each pair of legs 102A, 102B; 104A, 104B; and 105A, 105B at least one protrudes from the encapsulant 4. These legs may be used to electrically connect the semiconductor devices integrated in the first and second semiconductor bodies 103A, 103B to traces on a PCB (Printed Circuit Board), which is not shown.

Figure 12 shows a vertical cross sectional view of a semiconductor arrangement according to another example, wherein from the encapsulant 4 only the outline is shown in Figure 4. The semiconductor arrangement shown in Figure 12 is based on a semiconductor arrangement shown in Figure 6 when implemented with a conductor 3 as illustrated in Figures 9 or 10. The semiconductor arrangement shown in Figure 12 is an SMD (Surface Mounted Device, Surface Mountable Device) and is different from the semiconductor arrangement shown in Figure 6 in that the contact leg 104B has a contact section that is essentially in the same plane as the second surface 12B of the second arrangement 1B. Figure 12 shows a vertical cross sectional view in a section plane that cuts through the (source) leg 104B of the second arrangement 1B. Lead frame 101A is connected to lead frame 101B in a section plane not illustrated in Figure 12.

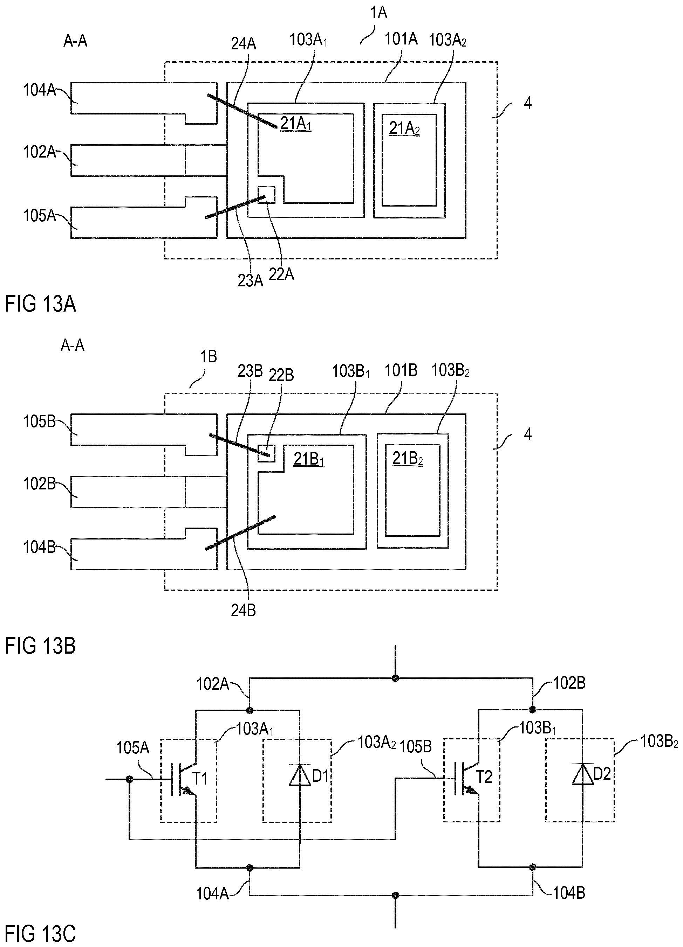

In the examples explained with reference to Figures 6 to 12, one semiconductor body 103A, 103B is arranged on each of the carriers 101A, 101B. This, however, is only an example. It is also possible to arrange two or more semiconductor bodies on each carrier. One example of an arrangement of this type is illustrated in Figures 13A-13C.

Figure 13A shows a top view of a first arrangement 1A and Figure 13B shows a top view of a second arrangement 1B. These first and second arrangements 1A, 1B are based on the first and second arrangements 1A, 1B illustrated in Figures 7A and 7B, respectively, and are different from these first and second arrangements 1A, 1B in that each of the first arrangement 1A and the second arrangement 1B shown in Figures 13A and 13B, respectively, includes two semiconductor bodies 103A₁, 103A₂, 103B₁, 103B₂. Each of these semiconductor bodies 103A₁-103B₂ includes an electrode 21A₁, 21A₂. 21B₁, 21B₂. According to one example, a connector 3 (not shown in Figures 13A and 13B), in the finished semiconductor arrangement, is in electrical contact with each of these electrodes 21A₁-21B₂, so that the connector 3 electrically connects these electrodes with each other. In general, one connector 3 may connect the one or more electrodes of the first arrangement 1A with each other and with one or more electrodes of the second arrangement 1B.

According to one example, as explained with reference to Figures 7A and 7B, a vertical transistor device such as a MOSFET or an IGBT may be integrated in each of the first semiconductor bodies 103A₁, 103B₁ of the first and second arrangements 1A, 1B. Further, a vertical diode may be integrated in each of the second semiconductor bodies 103A₂, 103B₂ of the first and second arrangements 1A, 1B. An equivalent circuit diagram of a semiconductor arrangement of the type illustrated in Figures 13A and 13B, when a vertical transistor device is integrated in each of the first semiconductor bodies 103A₁, 103B₁ and a vertical diode is integrated in each of the second semiconductor bodies 103A₂, 103B₂, is illustrated in Figure 13C. Just for the purpose of illustration it is assumed that the vertical transistor device is an IGBT. Nevertheless, any other type of vertical transistor device such as a vertical MOSFET, or a vertical JFET (Junction Field-Effect Transistor) may be used as well. Further, in the example illustrated in Figures 7A-7C as well as in the example illustrated in Figures 13A-13C, different types of transistor devices may be connected in parallel. That is, a first type of transistor device, such as a MOSFET, may be integrated in one of the semiconductor bodies 103A, 103B, and a second type of transistor device, such as an IGBT, may be integrated in the other one of the semiconductor bodies 103A, 103B.

A circuit of the type shown in Figure 13C may be obtained by implementing the vertical transistor devices such that the electrodes 21A₁, 21B₁ of the first semiconductor bodies 103A₁, 103B₁ form the source electrodes (emitter electrodes) of the IGBTs T1, T2 and by implementing the vertical diodes such that the electrodes 21A₂, 21B₂ of the second semiconductor bodies 103A₂, 103B₂ form anodes of the respective diodes D1, D2.

The semiconductor arrangement shown in Figures 13A-13C includes two transistor devices T1, T2 and two diodes D1, D2. This, however, is only an example. According to another example, one of these first and second arrangements 1A, 1B includes a transistor device and a diode while the other one of these first and second arrangements 1A, 1B only includes a transistor device or only includes a diode.

In the examples explained before, the transistor device is a vertical transistor device, that is, a transistor device in which a source node (emitter node) is formed on a first surface of the respective semiconductor body 103A, 103B, 103A₁, 103B₁ and the drain node (collector node) is formed on an opposite side of the respective semiconductor body 103A, 103B, 103A₁, 103B₁. This, however, is only an example. According to another example, a lateral transistor device is integrated in each of the first semiconductor body 103A, 103B.

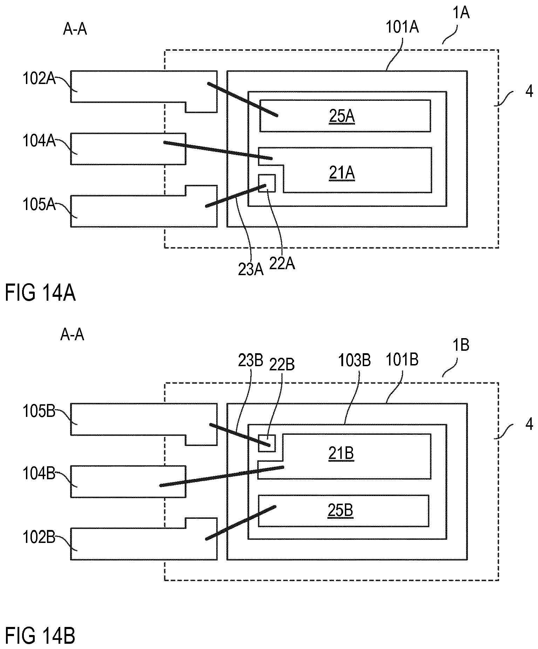

This is illustrated in Figures 14A and 14B, wherein Figure 14A shows a top view of a first arrangement 1A that includes a lateral transistor device and Figure 14B shows a top view of a second arrangement that includes a lateral transistor device. The first arrangement 1A shown in Figure 14A is based on the first arrangement 1A shown in Figure 7A and is different from the first arrangement 1A shown in Figure 7A in that a lateral transistor device is integrated in the first semiconductor body 103A. This lateral transistor device includes a first electrode 21A forming a source node (emitter node) of the transistor device and a second electrode 25A forming a drain node (collector node) of the transistor device. The first electrode 21A is connected to the source leg 104A and the second electrode 25A is connected to the drain leg 102A. Each of the source leg 104A and the drain leg 102A may be separated from the carrier 101 A. According to another example, one of the source leg 104A and the drain leg 102A is connected to the carrier 101A. Equivalently, the second arrangement 1B shown in Figure 14B includes a lateral transistor device integrated in the semiconductor body 103B wherein this lateral transistor device includes a first electrode 21B and a second electrode 25B. The first electrode 21B forms the source node of the transistor device and is connected to the source leg 104B, and the second electrode 25B forms the drain node and is connected to the drain leg 102B. Each of these source and drain legs 104B, 102B may be separated from the carrier 101B. According to another example, one of the source leg 104B and the drain leg 102B is connected to the carrier 101B.

In the examples explained with reference to Figures 6-14B, each of the legs 102A-105B protrude from the encapsulant 4 on the same side. This, however, is only an example. According to another example (not shown) legs may protrude from the encapsulant 4 on two or more different sides.

In the examples explained with reference to Figures 6-14B, each of the first and second arrangements 1A, 1B includes a carrier 101A, 101B that is part of a leadframe and one semiconductor body 103A, 103B mounted on the respective carrier 101A, 101B. This however, is only an example. A connector 3 of the type explained before is not restricted to be used in a semiconductor arrangement that includes first and second arrangements 1A, 1B of this type.

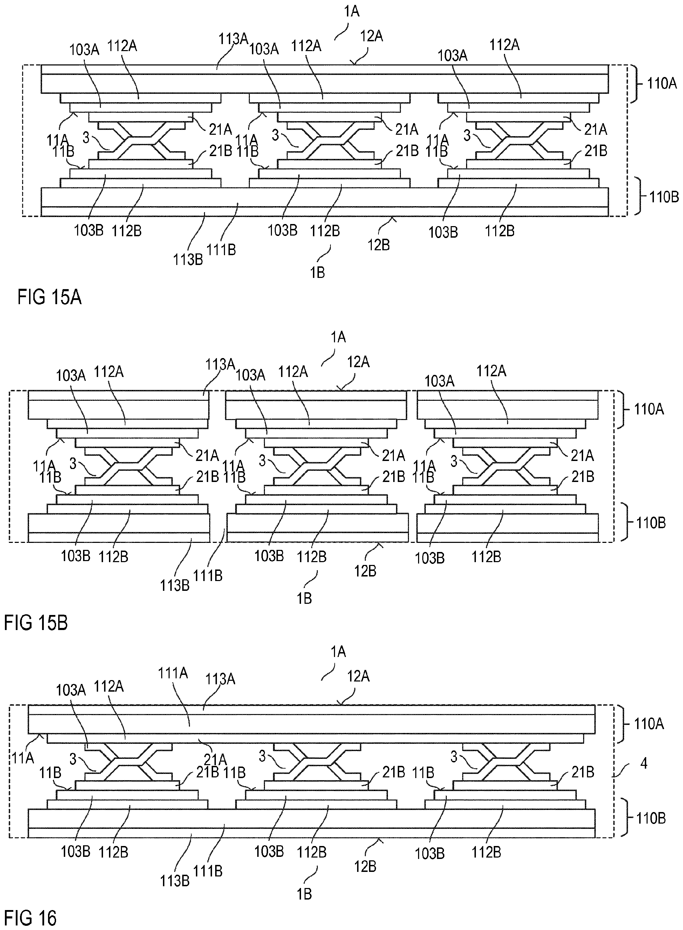

A semiconductor arrangement according to another example is shown in Figure 15A. In this example, each of the first and second semiconductor arrangements 1A, 1B includes an insulating substrate 110A, 110B as a respective carrier 110A, 110B. The insulating substrate 110A, 110B may include one of a DCB (Direct Copper Bonding) substrate, an AMB (Active Metal Bracing) substrate, a PCB (Printed Circuit Board) based substrate, or an IMS (Isolating Metal Substrate). The IMS may include at least one of Al₂O₃, Si₃N₄, BN, AlN or diamond as the isolator.

The substrate 110A of the first arrangement 1A is referred to as first substrate and the substrate 110B of the second arrangement 1B is referred to as second substrate in the following. Further, a plurality of first semiconductor bodies 103A is mounted on the first substrate 110A and a plurality of second semiconductor bodies 103B is mounted on the second substrate 110B. The semiconductor arrangement further includes a plurality of connectors 3, wherein each of these connectors 3 electrically connects the electrode 21A of a respective one of the first semiconductor bodies 103A with the electrode 21B of a respective one of the second semiconductor bodies 103B.

Referring to Figure 15A, the first substrate 110A includes a plurality of first metallizations 112A that are spaced apart from each other and arranged on a first surface of the first substrate 110A, wherein each of the first semiconductor bodies 103A is mounted on a respective one of these first metallizations 112A. Equivalently, the second substrate 110B includes a plurality of first metallizations 112B that are spaced apart from each other and arranged on a first surface of the second substrate, wherein each of the second semiconductor bodies 103A is mounted on a respective one of these first metallizations 112B. The first substrate 110A further includes a second metallization 113A on a second surface, wherein this second metallization forms the second surface 12A of the first arrangement 1A. Equivalently, the second substrate 110B further includes a second metallization 113B on a second surface, wherein this second metallization forms the second surface 12B of the second arrangement 1B.

Instead of providing one first substrate 110A and one second substrate 110B each having a plurality of first metallizations 112A, 112B several first substrates 110A, 110B may be provided, as illustrated in Figure 15B.

Any kind of semiconductor device or semiconductor circuit may be integrated in the semiconductor bodies 103A, 103B of the semiconductor arrangement shown in Figures 15A and 15B. According to one example, a transistor device is integrated in each of these semiconductor bodies 103A, 103B. Contact terminals (contact pins) of these transistor device protrude from the encapsulant at positions not illustrated in Figures 13A and 13B. According to another example, a transistor device is integrated in each of the semiconductor bodies 103A of the first arrangement 1A and a diode is integrated in each of the semiconductor bodies 103B of the second arrangement 1B.

Although, in the examples explained before, each of the first and second arrangements 1A, 1B includes a semiconductor body, this is only an example. According to another example, only one of the first and second arrangements 1A, 1B includes a semiconductor body with an electrode, while the electrode of the other one of the first and second arrangements serves to connect the electrode of the semiconductor body to an external terminal, to another electrode of the same semiconductor body or to an electrode on another semiconductor body of the one of the first and second arrangements 1A. 1B. One example of a semiconductor arrangement of this type is illustrated in Figure 14.

The semiconductor arrangement according to Figure 14 is based on the semiconductor arrangement according to Figure 13 and is different from the semiconductor arrangement according to Figure 13 in that only the second arrangement 1B includes a plurality of semiconductor bodies 103B. Further, the first arrangement includes only one first metallization 112A, wherein this first metallization forms the electrode 21A of the first arrangement 1A. Each of the connectors 3 is connected to the electrode 21A of the first arrangement so that this electrode 21A serves to connect the electrodes 21B of the semiconductor bodies 103B of the second arrangement 1B with each other.

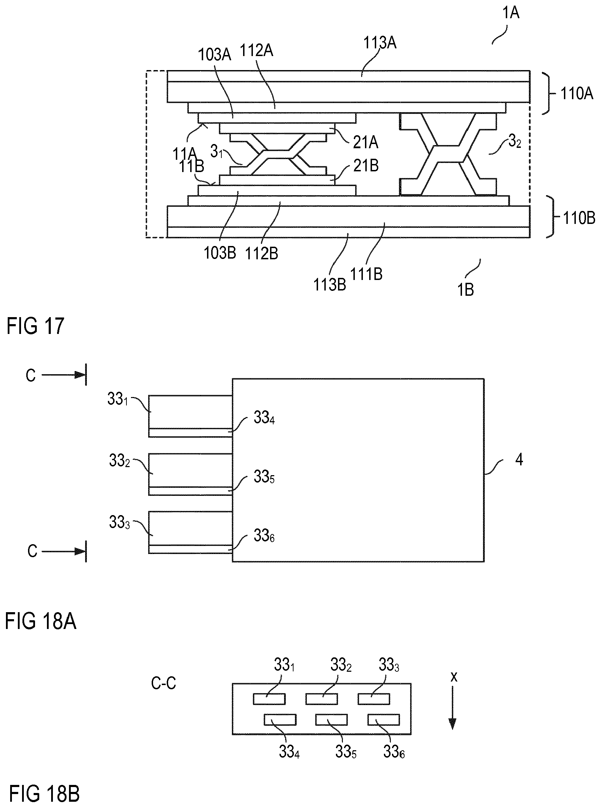

According to yet another example illustrated in Figure 17, a first connector 3₁ is connected between the first metallizations 112A, 112B of the substrates 110A, 110B and a second connector 3₂ is connected between the second metallizations 113A, 113B of the substrates 110A, 110B.

In general, a semiconductor arrangement may include a plurality of connectors of the type explained above, wherein each of these connectors connects at least one electrode or metallization of the first arrangement 1A with at least one electrode or metallization of the second arrangement 1B. The electrodes connected by one connector 3 can be various kinds of electrodes or metallizations. Examples of these electrodes or metallizations include, but are not restricted to, contact electrodes of transistors or diodes; contact electrodes of sensors, such as temperature sensors, current sensors, or voltage sensors integrated in a semiconductor body; or metallizations of a substrate, as illustrated in Figure 17, for example. One connector may connect the same type of electrodes with each other, such as, for example, source electrodes of two transistors, or may connect different types of electrodes with each other, such as, for example, a source electrode of a transistor with an anode electrode of a diode.

Referring to the above, one semiconductor arrangement may include a plurality of connectors 3. Further, referring to Figure 10, one connector 3 may include a flat terminal section 33 that protrudes from the encapsulant 4 and forms a contact leg (contact pin). Referring to Figure 18A, which shows a top view of a semiconductor arrangement according to one example, the connectors may be arranged such that terminal sections 33₁, 33₂, 33₃ of several connectors protrude from the encapsulant 4 on one side, wherein these terminal sections 33₁, 33₂, 33₃ are arranged next to each other in a lateral direction along the one side. Referring to Figure 18B, which shows a side view of the semiconductor arrangement, two (or more) terminal sections 33₁-33₆ may be arranged next to each other in the vertical direction x, wherein the terminal sections that are arranged next to each other in the vertical direction may be offset in the lateral direction. The latter, however, is only an example. The terminal sections that are arranged next to each other in the vertical direction x may also be aligned relative to each other.

## Claims

1. A semiconductor arrangement, comprising:
a first arrangement (1A) and a second arrangement (1B) each comprising a first surface (11A, 11B), a second surface (12A, 12B), and an electrode (21A, 21B) formed on the first surface (11A, 11B), wherein the first arrangement (1A) and the second arrangement (1B) are spaced apart from each other in a first direction (x) and arranged such that the first surface (11A) of the first arrangement (1A) faces the first surface (11B) of the second arrangement (1B), and wherein at least one of the first arrangement (1A) and the second arrangement (1B) comprises a semiconductor body (103A, 103B);
a connector (3) electrically connecting the electrode (21A) of the first arrangement (1A) and the electrode (21B) of the second arrangement (1B), wherein the connector (3) is compressible in the first direction (x); and
an encapsulant (4) filling a space between the first arrangement (1A) and the second arrangement (1B) and embedding the connector (3).

2. The semiconductor arrangement of claim 1, wherein the second surface (12A, 12B) of each of the first arrangement (1A) and the second arrangement (1B) is at least partially not covered by the encapsulant (4).

3. The semiconductor arrangement of any one of claims 1 to 3, wherein at least one of the first arrangement (1A) and the second arrangement (1B) comprises:
a carrier (101A, 101B) forming the second surface (12A, 12B);
a semiconductor body (103A, 103B) arranged on the carrier (101A, 101B), wherein a surface of the semiconductor body (103A, 103B) facing away from the carrier (101A, 101B) forms the first surface (11A, 11B).

4. The semiconductor arrangement of claim 3, wherein the carrier (101A, 101B) is part of a leadframe.

5. The semiconductor arrangement of claim 3,
wherein the carrier is a substrate (110A) comprising:
an insulating carrier (111A, 111B), a first metallization (112A, 112B) formed on a first surface of the insulating carrier (111A, 111B) and a second metallization (113A, 113B) formed on a second surface of the insulating carrier (111A, 111B), wherein the second metallization (113A, 113B) forms the second surface (12A, 12B) of the respective arrangement (1A, 1B), and
wherein the semiconductor body (103A, 103B) is formed on the first metallization (112A, 112B).

6. The semiconductor arrangement of any one of claims 3 to 5,
wherein a transistor device is integrated in the semiconductor body (103A, 103), and
wherein a load node of the transistor device is connected to the electrode (21A, 21B).

7. The semiconductor arrangement of any one of claims 3 to 5,
wherein a diode is integrated in the semiconductor body (103A, 103), and
wherein a load node of the diode is connected to the electrode (21A, 21B).

8. The semiconductor arrangement of any one of claims 1 to 7, further comprising:
a contact pin (104A, 104B) protruding from the encapsulant (4), wherein the connector (3) is electrically connected to the contact pin.

9. The semiconductor arrangement of any one of claims 1 to 7, wherein the connector (3) comprises a terminal section (33) that protrudes from the encapsulant (4).

10. The semiconductor arrangement of any one claims 1 to 9,
wherein a pressure contact is formed between the connector (3) and the electrode of at least one of the first arrangement (1A) and the second arrangement (1B).

11. The semiconductor arrangement of any one of claims 1 to 9,
wherein the connector (3) is fixed at the electrode (21A, 21B) of at least one of the first arrangement (1A) and the second arrangement (1B) by an electrically conducting compound.

12. The semiconductor arrangement of any one of the preceding claims,
wherein the encapsulant (4) is a mold compound.

13. A method comprising:
placing a semiconductor arrangement in a first section (51) of a mold (50);
closing the mold (5) by placing a second section (53) of the mold (50) on top of the first section (51); and
filling a space (53) inside the mold (50) by an encapsulant (4),
wherein the semiconductor arrangement comprises:
a first arrangement (1A) and a second arrangement (1B) each comprising a first surface (11A, 11B), a second surface (12A, 12B), and an electrode (21A, 21B) formed on the first surface (11A, 11B), wherein the first arrangement (1A) and the second arrangement (1B) are spaced apart from each other in a first direction (x) and arranged such that the first surface (11A) of the first arrangement (1A) faces the first surface (11B) of the second arrangement, and wherein at least one of the first arrangement and the second arrangement comprises a semiconductor body (103A, 103B); and
a connector (3) arranged between the electrode (21A) of the first arrangement (1A) and the electrode (21B) of the second arrangement (1B) and electrically connecting the electrode (21A) of the first arrangement (1A) and the electrode (21B) of the second arrangement (1B), wherein the contact element (3) is compressible in the first direction (x), and
wherein closing the mold (50) comprises compressing the connector (3) in the first direction (x).

14. The method of claim 13, wherein filling the space inside the mold (51) is part of a transfer molding process.

15. The method of claim 13 or 14, wherein compressing the connector (3) comprises compressing the connector (3) by a distance of between 50 micrometers and 500 micrometers.
